(19) Europäisches Patentamt / European Patent Office / Office européen des brevets

(11) **EP 3 928 378 B1**

(12) **FASCICULE DE BREVET EUROPEEN**

(45) Date de publication et mention de la délivrance du brevet:
**28.08.2024 Bulletin 2024/35**

(21) Numéro de dépôt: **20705070.9**

(22) Date de dépôt: **18.02.2020**

(51) Classification Internationale des Brevets (IPC):
**H01Q 1/38** *(2006.01)* **H01Q 9/27** *(2006.01)*

(52) Classification Coopérative des Brevets (CPC):
**H01Q 9/27; H01Q 1/38**

(86) Numéro de dépôt international:
**PCT/EP2020/054262**

(87) Numéro de publication internationale:
**WO 2020/169619 (27.08.2020 Gazette 2020/35)**

(54) **ANTENNE LARGE BANDE, NOTAMMENT POUR SYSTÈME D'IMAGERIE À MICROONDES**

BREITBANDANTENNE, INSBESONDERE FÜR EIN MIKROWELLENBILDGEBUNGSSYSTEM

WIDEBAND ANTENNA, IN PARTICULAR FOR A MICROWAVE IMAGING SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.02.2019 FR 1901784**

(43) Date de publication de la demande:
**29.12.2021 Bulletin 2021/52**

(73) Titulaire: **Manneschi, Alessandro**
**52100 Arezzo (IT)**

(72) Inventeur: **Manneschi, Alessandro**
**52100 Arezzo (IT)**

(74) Mandataire: **Regimbeau**
**20, rue de Chazelles**
**75847 Paris Cedex 17 (FR)**

(56) Documents cités:
**US-A- 6 137 453** **US-A1- 2005 243 013**
**US-A1- 2007 194 978** **US-A1- 2017 338 551**
**US-B1- 6 335 710**

**Description**

**Domaine d'application**

Le domaine d'application de la présente invention est une structure radiante planaire à large bande, travaillant préférentiellement sur la plage de fréquence de 15 GHz à 50 GHz, qui peut être utilisée comme élément de base pour la conception de réseaux d'antennes de transmission/réception pour les systèmes d'imagerie à microondes.

**Etat de la technique**

Professeur à l'Université de l'état du Ohio (USA) aux premières années '50, et successivement à l'Université de l'Illinois de 1954 à 1957, Victor Rumsey développa un fort intérêt pour la famille des antennes complémentaires, à savoir à impédance constante et égale à la moitié de l'impédance de l'espace libre à toutes les fréquences.

Une antenne auto complémentaire a la caractéristique que la partie métallique est congruente à celle non-métallique, c'est-à-dire que la deuxième peut être superposée à la première par un mouvement rigide dans un plan ou dans l'espace.

De nombreuses géométries auto complémentaires peuvent être dessinées. Rumsey, après avoir étudié ces structures pendant de nombreuses années, a établi que l'impédance et les propriétés de radiation sont indépendantes de la fréquence si la forme de l'antenne est spécifiée seulement en termes des angles. Cette loi est aujourd'hui connue comme principe de Ramsey.

Le principe de Ramsey fut appliqué expérimentalement par John Dyson à l'Université de l'Illinois qui construisit, en 1958, la première antenne à spirale avec caractéristiques indépendantes avec la fréquence.

Un type d'antenne complémentaire, connue comme double spirale d'Archimède, fut perfectionnée par Arthur Marston et Henri Coleman, de la US Navy, qui l'équipèrent avec des propriétés directionnelles et qui brevetèrent les solutions correspondantes en 1958 et 1959 respectivement.

Plus récemment de nombreuses méthodologies de réalisation des antennes à spirales ont été proposées et brevetées, par exemple dans les brevets n° US 5 313 216 et US 6 137 453.

Le brevet US 8 390 529 montre en particulier une construction à circuit imprimé multicouche où l'antenne à spirale est positionnée sur la première surface de la première couche et un plan de masse est positionné sur la deuxième face de la première couche (qui correspond aussi à la première face de la deuxième couche). Ce plan de masse représente l'intégration dans le circuit imprimé d'une solution classique pour rendre le rayonnement de l'antenne à spirale mono directionnelle. Un plan de masse est aussi positionné sur la deuxième face de la deuxième couche. Ce plan est utilisé comme plan de masse pour la connexion d'un système d'alimentation de l'antenne, par exemple une tresse conductrice de blindage d'un câble coaxial.

Cette solution, même si elle présente l'avantage de l'intégration dans un circuit imprimé, ne permet pas d'obtenir des caractéristiques de rayonnement à large bande optimisées, notamment en termes d'adaptation de l'impédance et de transmission entre une antenne d'émission et une antenne de réception. Cette limitation est causée par les résonances aux fréquences pour lesquelles l'épaisseur de la première couche correspond à un multiple d'un quatrième de la longueur d'onde dans le matériel qui constitue la couche même.

Le graphique annexé en figure 1 montre la réponse en fréquence (paramètre S21) d'une antenne conforme au brevet US 8 390 529. On peut observer les problèmes causés par les résonances et le défaut d'uniformité de la réponse.

Un deuxième problème de la construction montrée dans le brevet US 8 390 529 est l'impossibilité d'utiliser la deuxième face de la deuxième couche pour la réalisation des lignes de transmission et pour le montage des circuits à hyperfréquence car il s'agit d'un plan de masse pour permettre la connexion de l'alimentation de l'antenne.

Un troisième problème de la construction montrée dans le brevet US 8 390 529 est le couplage entre les antennes adjacentes, comme montré dans la figure 2 du même brevet, causé par le possible passage d'une partie de l'énergie électromagnétique par le matériel diélectrique de la première couche. Par conséquent cette solution n'est pas adaptée pour la construction de réseaux d'antennes.

Le document US 6 335 710 décrit une structure d'antenne comprenant, successivement, une antenne spiralée placée entre une couche en matériau ferroélectrique pouvant présenter une constante diélectrique comprise entre 80 et 1500 et une couche de diélectrique. Toutefois, une telle antenne ne peut être employée dans une structure radiante planaire à large bande en vue de son utilisation dans un système d'imagerie à microondes, dans la mesure où il s'agit d'une antenne accordable (« tunable » en anglais), dont la bande de fréquence est réduite. Le facteur Q de cette antenne est en effet très élevé afin de permettre de contrôler l'onde réfléchie dans la couche de matériau ferroélectrique.

Le document US 2005/243013 décrit une structure d'antenne comprenant un élément rayonnant balancé à spirale alimenté via un balun.

## Description de l'invention

L'invention a pour objectif de perfectionner l'état de la technique en proposant une antenne qui présente des propriétés supérieures à celles des antennes connues.

Pour cela l'invention propose une structure d'antenne et un circuit imprimé conformes aux revendications indépendantes annexées. Des modes de réalisation sont décrits dans les revendications dépendantes.

L'invention consiste dans une structure d'antenne intégrée dans un circuit imprimé comprenant deux couches de diélectrique, ayant la même constante diélectrique mais des épaisseurs différentes (ha pour la premier couche - au moins 1/8 de la longueur d'onde opérationnelle maximale - et hTL pour la deuxième couche), un élément rayonnant balancé à spirale sur la première face de la première couche diélectrique et une alimentation de l'antenne équilibrée par une ligne bifilaire équilibrée ayant la même impédance que l'antenne équilibrée, caractérisée par le fait que la ligne bifilaire équilibrée interconnecte l'antenne à spirale équilibrée à un couple de lignes de transmission à microbande, positionnées sur la deuxième face de la deuxième couche, où chaque ligne à microbande est adaptée pour présenter une impédance égale à la moitié de l'impédance de la ligne de transmission bifilaire et par le fait que en correspondance de la ligne équilibrée à microbandes, sur la première face de la deuxième couche, correspondant à la deuxième face de la première couche, est positionnée une plan de masse qui détermine, en fonction de l'épaisseur de la deuxième couche de diélectrique et de la distance entre le microbandes, l'impédance de transmission de la ligne équilibrée à microbandes.

D'autres caractéristiques, buts et avantages de la présente invention apparaitront à la lecture de la description détaillée qui va suivre et en regard des dessins annexés, donnés à titre d'exemples non limitatifs et sur lesquels :

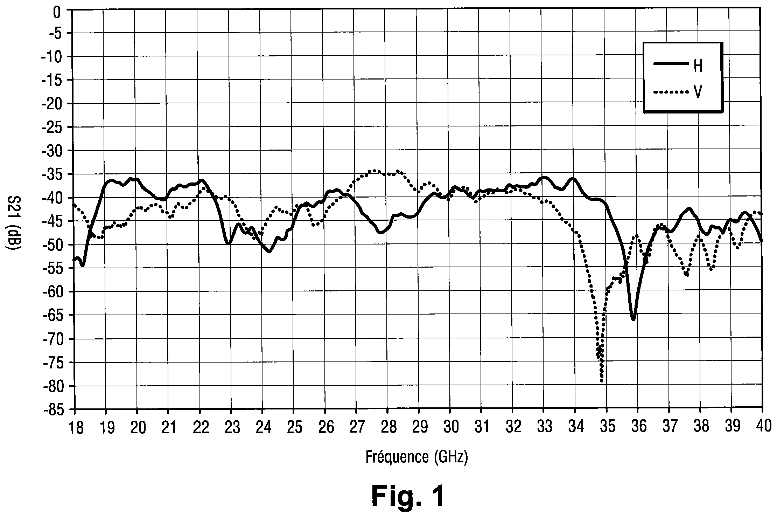

La figure 1 représente la réponse en fréquence (paramètre S21) d'une antenne conforme au brevet US 8,390,529,

La figure 2 représente la réponse en fréquence (paramètre S21) d'une antenne conforme à la présente invention,

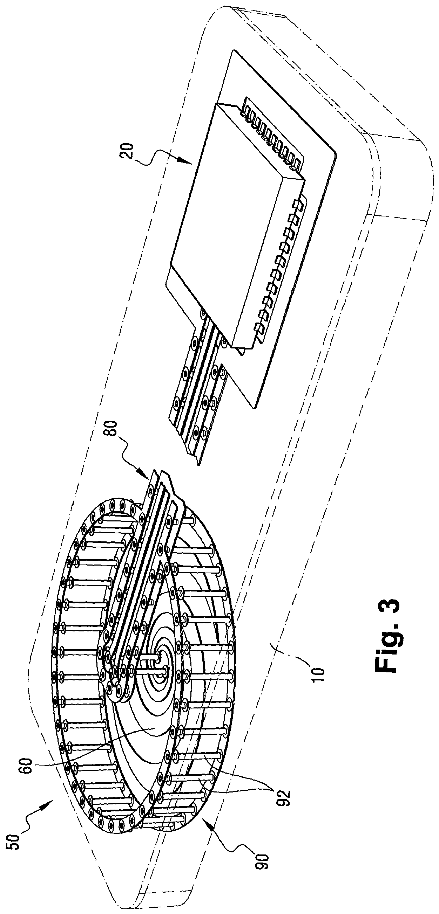

La figure 3 représente un exemple d'implantation d'une antenne conforme à la présente invention, associée à des composants hyperfréquence, implantés sur un circuit imprimé commun,

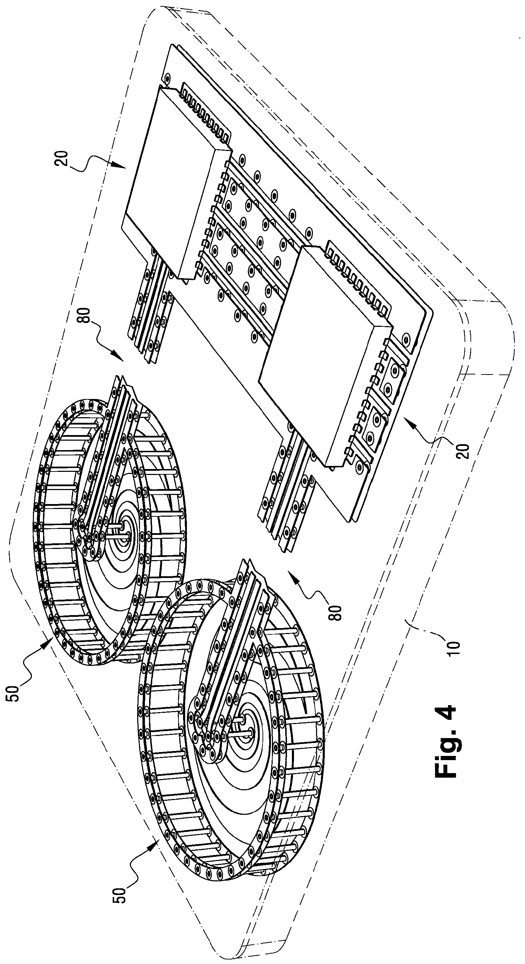

La figure 4 représente une variante de la figure 3 et plus précisément un exemple d'implantation de deux antennes adjacentes conformes à la présente invention, associées à des composants hyperfréquence respectifs, implantés sur un circuit imprimé commun,

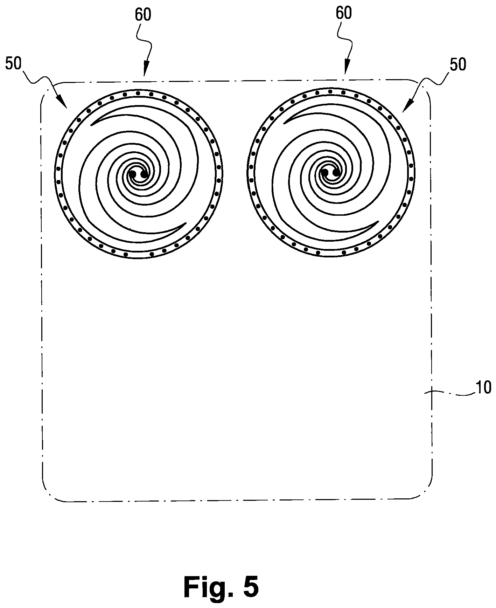

La figure 5 représente une antenne à spirale équilibrée conforme à la présente invention, sur la première face de la première couche,

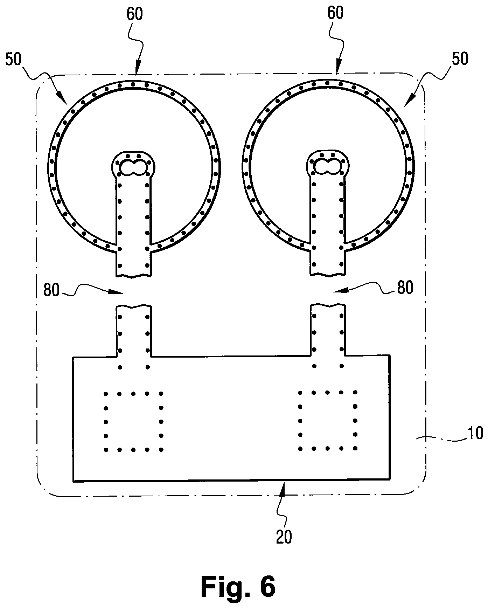

La figure 6 représente une vue de la masse sur la deuxième face de la première couche (correspondant à la première face de la deuxième couche) d'une antenne conforme à la présente invention,

La figure 7 représente les lignes de transmission à microbande connectant les antennes à des puces à hyperfréquence et les puces entre elles, et

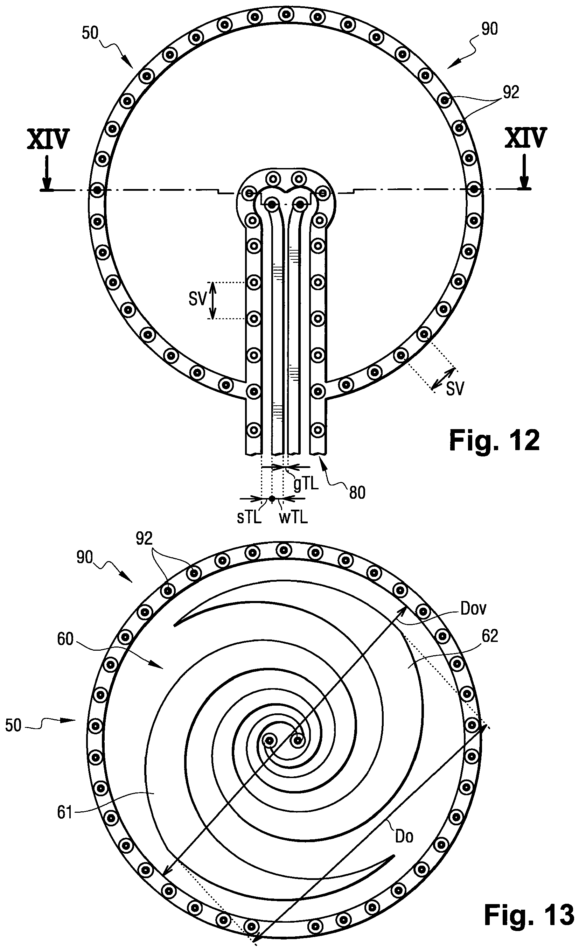

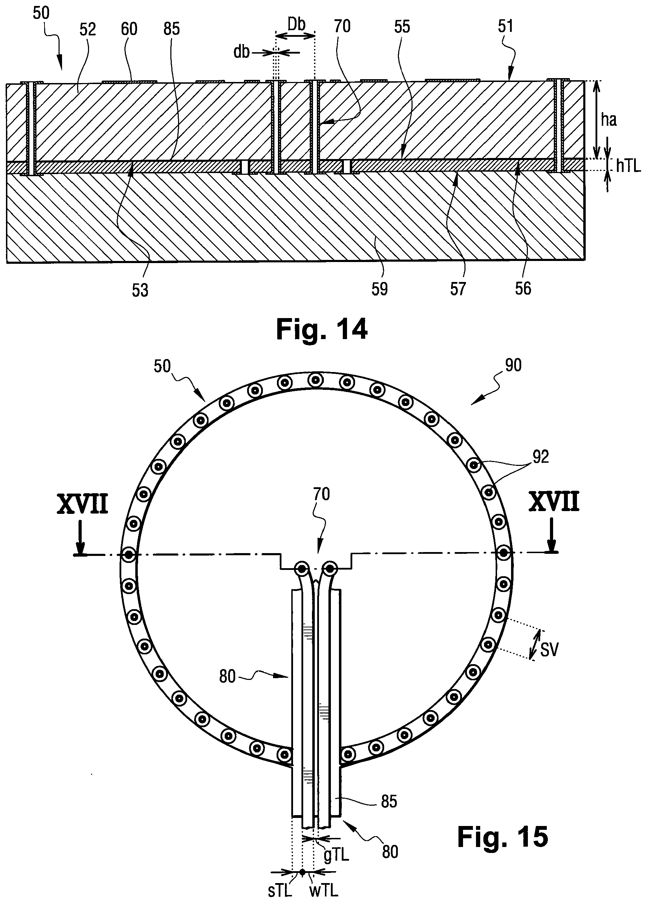

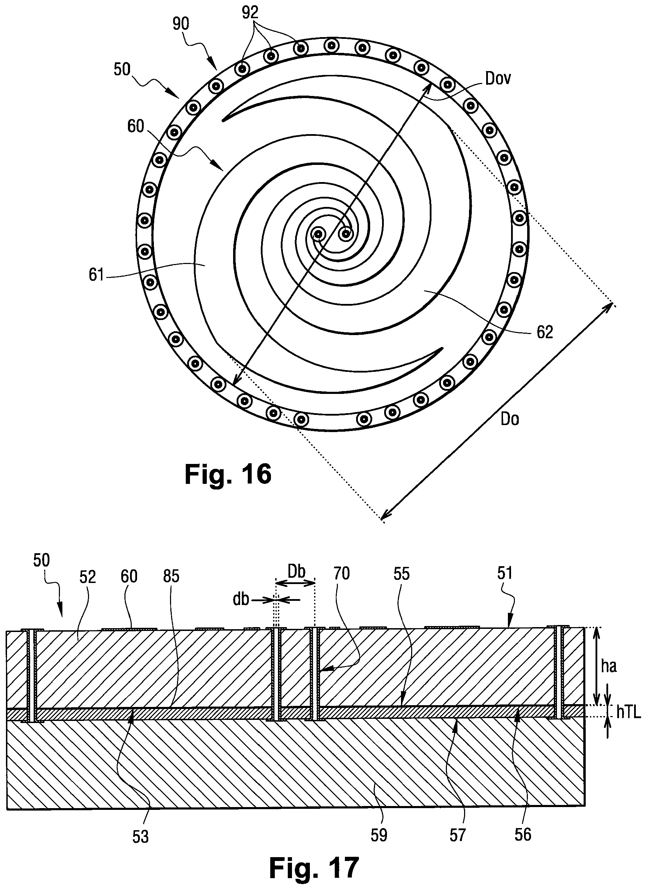

Les figures 8 à 17 représentent différentes vues en perspective, en plan ou en coupe d'antennes conformes à la présente invention.

## Description Détaillée

On aperçoit sur les figures annexées une antenne 50 conforme à la présente invention, intégrée dans un circuit imprimé 10.

L'antenne 50 comprend deux couches de diélectrique 52, 56. Chaque couche diélectrique 52, 56 présente une première face 51, 55, ou face supérieure, et une deuxième face 53, 57, ou face inférieure, qui est opposée à la première face 51, 55. La deuxième face 53 de la première couche 52 est positionnée en face de la première face 55 de la deuxième couche 56.

Les deux couches de diélectrique 52, 56, ont la même constante diélectrique mais des épaisseurs différentes. L'épaisseur de la première couche 52 est référencée ha. Elle est égale au moins à 1/8 de la longueur d'onde opérationnelle maximale. De la sorte, l'épaisseur formée par la première couche 52 de diélectrique n'est pas résonnante et l'antenne 50 peut fonctionner en large bande.

Dans une forme de réalisation, afin de limiter l'encombrement de la structure d'antenne, l'épaisseur ha de la première couche 52 est inférieure ou égale à la moitié de la longueur d'onde opérationnelle maximale. On a donc :

$$\frac{\lambda_{max}}{8} \leq h_a \leq \frac{\lambda_{max}}{2}$$

où $\lambda_{max}$ est la longueur d'onde opérationnelle maximale.

Par exemple, l'épaisseur ha de la première couche diélectrique 52 est égale à un quart de la longueur d'onde opérationnelle maximale (1/4 $\lambda_{max}$).

L'épaisseur de la deuxième couche 56 est référencée hTL.

La première couche 52 et la deuxième couche 56 peuvent être réalisées dans tout matériau diélectrique adapté, notamment tout matériau diélectrique susceptible d'être utilisé pour la réalisation d'un circuit imprimé. Leur constante diélectrique $\varepsilon_r$ est en outre faible afin de garantir que la structure d'antenne irradie et que l'énergie ne reste pas confinée dans la première couche 52. Par exemple, le matériau diélectrique de la première et de la deuxième couche 52, 56 peut présenter une constante diélectrique $\varepsilon_r$ supérieure ou égale à 2 et inférieure ou égale à 4.

L'antenne 50 comprend en outre un élément rayonnant équilibré à spirale 60 sur la première face 51 de la première couche diélectrique 52 et une alimentation de l'antenne équilibrée 50 par une ligne bifilaire équilibrée 70 ayant la même impédance que l'élément rayonnant équilibré 50.

Dans une forme de réalisation, l'élément rayonnant 60 comprend deux brins symétriques 61, 62. Les brins 61 et 62 divergent progressivement du centre de l'antenne 50, où ils sont reliés à l'alimentation, vers sa périphérie. L'invention n'est pas limitée au mode de réalisation particulier illustré sur les figures annexées, que ce soit quant à la géométrie de chaque brin de l'antenne que quant au nombre de brins.

La ligne bifilaire équilibrée 70 interconnecte l'élément rayonnant équilibré à spirale 50 à un couple de lignes de transmission à microbande 80, positionnées sur la deuxième face 57 de la deuxième couche 56. Chaque ligne à microbande 80 est adaptée pour présenter une impédance égale à la moitié de l'impédance de la ligne de transmission bifilaire 70. En correspondance de la ligne équilibrée à microbandes 80, sur la première face 55 de la deuxième couche 56, correspondant à la deuxième face 53 de la première couche 52, est positionnée une plan de masse 85 qui détermine, en fonction de l'épaisseur hTL de la deuxième couche 56 de diélectrique et de la distance gTL entre les microbandes, l'impédance de transmission de la ligne équilibrée à microbandes 80.

Dans une forme de réalisation, l'épaisseur hTL de la deuxième couche 56 est strictement inférieure à l'épaisseur ha de la première couche 52. En effet, comme cela a été précisé plus haut, l'épaisseur ha de la première couche est au moins égale à $\lambda_{max}/8$ afin de permettre le rayonnement de la structure d'antenne. Par ailleurs, l'épaisseur hTL de la deuxième couche est déterminée par les dimensions des lignes de transmission à microbande 80 et notamment leur épaisseur. Or, dans la mesure où on privilégie des lignes de transmission à microbandes d'épaisseur raisonnable, l'épaisseur hTL reste faible et en tout état de cause inférieure à l'épaisseur ha de la première couche.

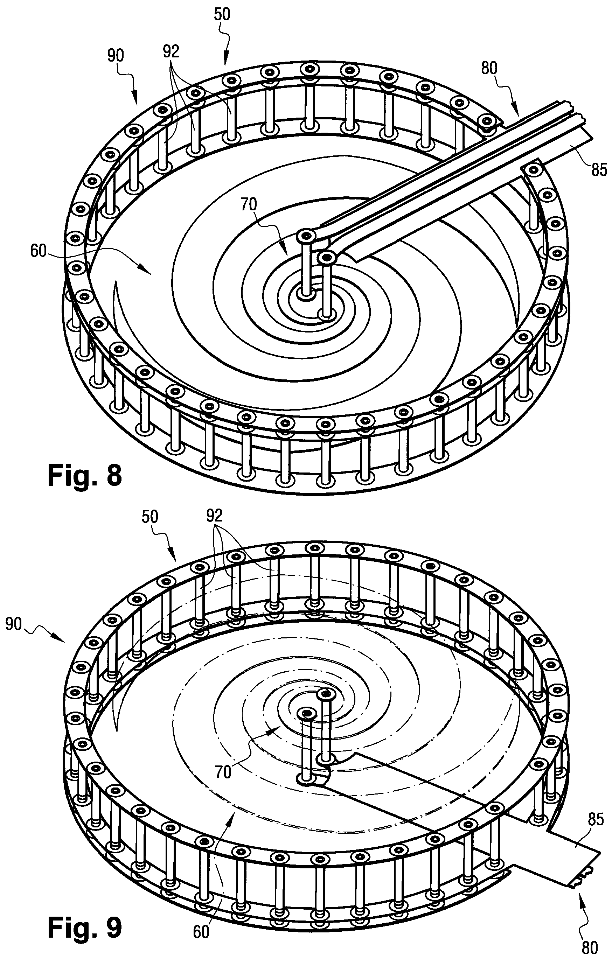

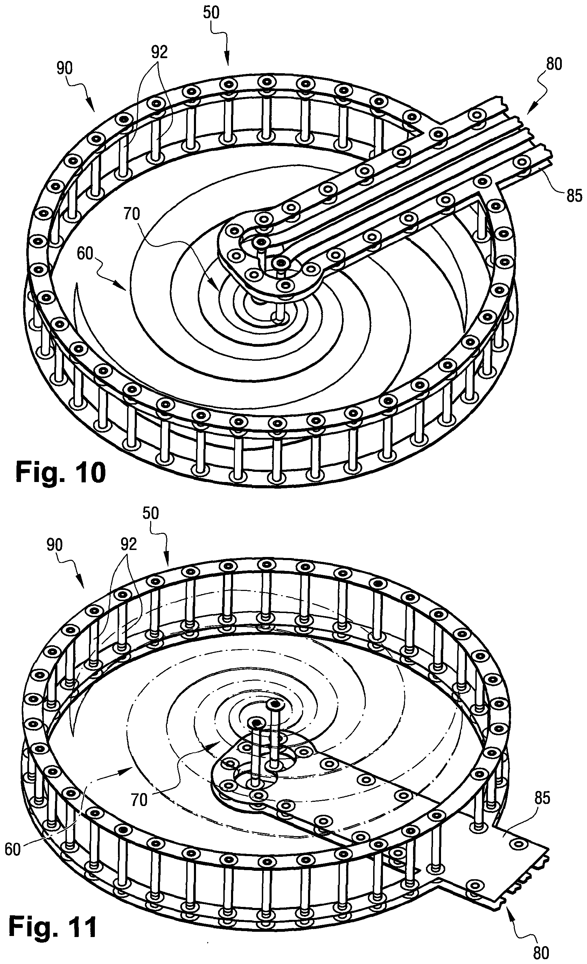

De plus, comme cela est visible par exemple sur les figures 9 et 11, la ligne bifilaire équilibrée n'est pas raccordée au plan de masse 85. Plus précisément, le plan de masse 85 présente, à proximité des fils de la ligne bifilaire équilibrée 70, des ajours sensiblement circulaires dont le diamètre est supérieur au diamètre de chaque fil de la ligne 70, de sorte que le plan de masse 85 s'étend à distance desdits fils.

Dans une forme de réalisation, la partie de raccordement des lignes à microbandes 80, qui est configurée pour être raccordée à l'alimentation et qui s'étend sensiblement parallèlement au plan de masse 85, diverge légèrement à proximité des fils de la ligne bifilaire équilibrée 70 (qui s'étendent sensiblement perpendiculairement et à distance du plan de masse 85) de sorte que chaque ligne 80 vienne en correspondance avec un fil associé de la ligne bifilaire équilibrée 70. Cette configuration de la partie de raccordement des lignes à microbande 80 permet ainsi une adaptation douce de l'impédance entre les lignes à microbande 80 et la ligne bifilaire équilibrée 70, améliore le transfert d'énergie et élimine les réflexions d'énergie.

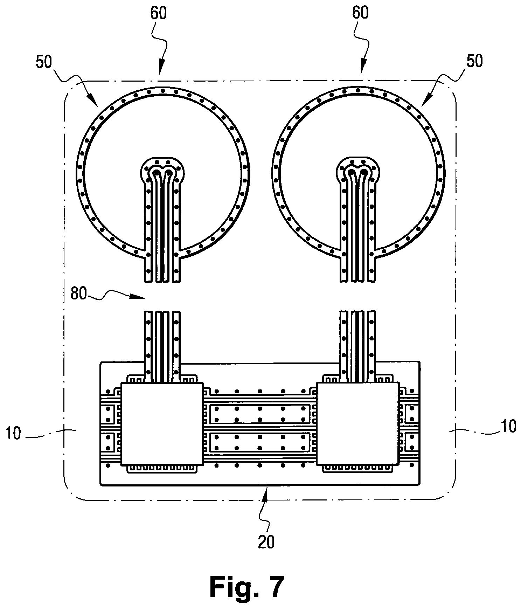

Dans une forme de réalisation, l'impédance $Z_{ant}$ de l'élément rayonnant à spirale 60 entre les points d'alimentation des brins 61 et 62 de l'élément rayonnant à spirale 60 est configurée pour être sensiblement égale à 100 $\Omega$ (à 20 % près). De plus, la ligne bifilaire équilibrée 70 présente une impédance, entre ses fils, sensiblement égale à l'impédance $Z_{ant}$ de l'élément rayonnant à spirale 60, soit environ 100 $\Omega$ (à 20 % près). L'impédance de chaque ligne de transmission à microbandes 80 est par ailleurs choisie de sorte que chaque ligne présente une impédance par rapport à la masse égale à environ 50 $\Omega$ de sorte que l'impédance entre les lignes 80 soit égale à environ 100 $\Omega$ (à 20 % près). Grâce à cette configuration, il est possible de monter directement des composants hyperfréquence 20 (dont l'impédance balancée (équilibrée) des entrées et des sorties est, dans la majorité des cas, égale à environ 100 $\Omega$) sur la même couche que les lignes à microbandes 80 (c'est-à-dire sur la deuxième face 57 de la deuxième couche 56), sans nécessiter l'ajout d'un composant d'adaptation intermédiaire tel qu'un élément balun (balanced-unbalanced en anglais, pour équilibré-non équilibré) entre le composant 20 et les lignes de transmission à microbande 80. Cette connexion directe est notamment visible sur la figure 7, qui illustre qu'un composant hyperfréquence monté directement sur la structure d'antenne, sans nécessiter l'ajout d'un circuit d'adaptation ou d'une ligne externe comprenant un balun. Le balun étant un composant très volumineux et coûteux, cette suppression présente l'avantage de réduire drastiquement l'encombrement et le coût de la structure d'antenne.

L'élément rayonnant à spirale 50 est entouré par une paroi 90 composée par des connexions métalliques verticales 92, avec un pas sv entre les connexions 92 inférieur à ¼ de la longueur d'onde minimale de travail afin d'obtenir un blindage efficace capable de confiner le champ microondes :

$$SV \; < \; \frac{\lambda_{min}}{4}$$

Dans le cas d'une antenne 50 dont les brins 61, 62 sont divergents, la paroi 90 peut être de forme sensiblement circulaire.

L'élément rayonnant à spirale 60 formant un dipôle électrique, la longueur curviligne des

brins 61, 62 est de préférence sensiblement égale à la moitié de la longueur d'onde opérationnelle maximale $\lambda_{max}$, de sorte que le courant soit nul au niveau de l'extrémité externe des brins 61, 62. La paroi 90 est donc dimensionnée de sorte que le diamètre maximal Do de l'élément rayonnant à spirale 60 soit compris entre 0.5 et 1.5 fois la longueur d'onde maximale : $0,75 \lambda_{max} \leq D_0 \leq 1,5 \lambda_{max}$

De plus, le Demandeur a déterminé de manière empirique (expérimental) que, pour limiter la zone de rayonnement du champ microonde tout en limitant l'influence de la paroi 90 sur l'impédance de l'élément rayonnant à spirale, le diamètre interne $D_{ov}$ moyen de la paroi respecte l'équation suivante :

$$(D_0 + 0{,}005\lambda_{max}) \leq D_{ov} \leq (D_0 + 0{,}25\lambda_{max})$$

Dans une forme de réalisation, toute la deuxième face 57 de la deuxième couche de diélectrique 56 (à l'exception de la surface autour de la ligne de transmission à microbandes 80 et de sa connexion à la ligne bifilaire équilibrée 70) est couverte par une couche 59 de matériel absorbant de la radiofréquence pour rendre le diagramme de radiation de l'antenne mono directionnel sans encourir de phénomènes de résonance. Dans une forme de réalisation, le matériel absorbant de la couche 59 peut comprendre un matériau absorbant un large spectre d'ondes millimétriques et/ou un matériau absorbant de micro-ondes élastomère à haute perte. Cette couche 90 permet de découpler les antennes adjacentes, réduisant ainsi au minimum le transfert d'énergie entre les antennes mêmes.

Les paramètres de conception de l'antenne sont les suivants :

$$0,75 \; \lambda_{max} \leq D_0 \leq 1,5 \; \lambda_{max}$$

$$\frac{\lambda_{max}}{8} \; \leq \; h_a \; \leq \; \frac{\lambda_{max}}{2}$$

$$(D_0 + 0{,}005\lambda_{max}) \leq D_{ov} \leq (D_0 + 0{,}25\lambda_{max})$$

$$SV \; < \; \frac{\lambda_{min}}{4}$$

$$Z_{ant} = \frac{120\pi}{2\sqrt{\varepsilon_{eff}}} \; \text{où} \; \varepsilon_{eff} = \frac{\varepsilon_r + 1}{2}$$

Où : $D_0$ représente le diamètre extérieur de l'élément rayonnant, c'est-à-dire son diamètre maximal.

$D_{ov}$ représente le diamètre interne moyen de la paroi 90.

$Z_{ant}$ représente l'impédance de l'élément rayonnant à spirale 60

$\varepsilon_{eff}$ représente la constante diélectrique efficace de l'élément rayonnant à spirale 60

$\varepsilon_r$ représente la constante diélectrique de la première couche 52.

Par exemple, pour une structure d'antenne dont la première couche 52 dont la constante diélectrique $\varepsilon_r$ est égale à 3, on obtient une impédance pour l'élément rayonnant à spirale 60 égale à environ 135 $\Omega$.

La structure d'antenne conforme à cette construction selon l'invention présente de nombreux avantages :

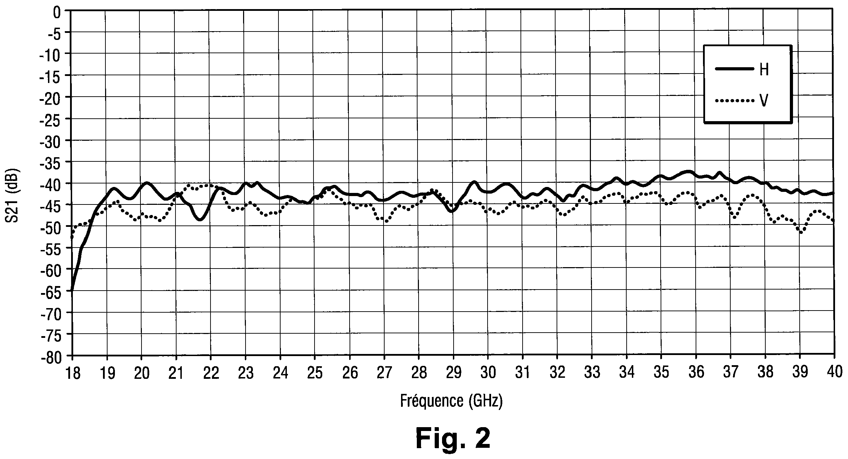

- Caractéristiques d'adaptation d'impédance optimales sur toute la plage des fréquences de travail
- Réponse en fréquence uniforme et constante sur toute la plage de travail (voir graphique représenté sur la figure 2)
- Fort découplage entre antennes adjacentes
- Adaptation à l'intégration sur le même circuit imprimé où les composants à hyperfréquence 20 sont montés avec forte économie de production (Figure 7).
- Selon une autre caractéristique avantageuse de l'invention, l'épaisseur de la première couche est inférieure à la moitié de la longueur d'onde opérationnelle maximale.

## Revendications

1. Structure d'antenne intégrée dans un circuit imprimé (10) comprenant :

   une première et une deuxième couches de diélectrique (52, 56) ayant une même constante diélectrique mais des épaisseurs différentes, la première et la deuxième couches de diélectrique (52, 56) présentant chacune une première face (51, 55) et une deuxième face (53, 57),
   un élément rayonnant équilibré à spirale (60) sur une première face (51) de la première couche diélectrique (52) et une alimentation de l'antenne équilibrée par une ligne bifilaire équilibrée (70) ayant une même impédance que l'élément rayonnant à spirale (60),
   la structure d'antenne (50) étant **caractérisée en ce que**
   la ligne bifilaire équilibrée (70) interconnecte l'antenne à spirale équilibrée (60) à un couple de lignes de transmission à microbande (80) équilibrées positionnées sur une deuxième face (57) de la deuxième couche (56), où chaque ligne de transmission à microbande (80) est adaptée pour présenter une impédance égale à la moitié de l'impédance de la ligne de transmission bifilaire (70) et
   **en ce qu'**elle comprend en outre une plan de masse (85) positionnée sur la première face (55) de la deuxième couche (56) et sur la deuxième face (53) de la première couche (52), en correspondance des lignes à microbandes (80), la plan de masse (85) étant configurée pour déterminer, en fonction de l'épaisseur de la deuxième couche de diélectrique (56) et de la distance entre les fils de la ligne bifilaire équilibrée (70), l'impédance de transmission des lignes de transmission à microbandes (80).

2. Structure d'antenne selon la revendication 1, dans laquelle la constante diélectrique de la première couche (52) et de la deuxième couche (56) est supérieure ou égale à 2 et inférieure ou égale à 4.

3. Structure d'antenne selon l'une des revendications 1 ou 2, dans laquelle l'élément rayonnant à spiral (60) est entouré par une paroi (90) composée par des connexions métalliques verticales (92).

4. Structure d'antenne selon la revendication 3, dans laquelle un pas entre les connexions (92) est inférieur à ¼ d'une longueur d'onde minimale de travail de l'élément rayonnant à spirale (60).

5. Structure d'antenne selon l'une des revendications 3 ou 4, dans laquelle un diamètre interne ($D_{ov}$) moyen de la paroi (90) est défini en fonction d'un diamètre maximal ($D_0$) de l'élément rayonnant à spirale (60) suivant l'équation suivante :

$$(D_0 + 0{,}005\lambda_{max}) \leq D_{ov} \leq (D_0 + 0{,}25\lambda_{max})$$

où $D_{ov}$ représentant le diamètre interne moyen de la paroi (90)
$D_0$ représente le diamètre extérieur maximal de l'élément rayonnant à spirale (60).

6. Structure d'antenne selon l'une des revendications 1 à 5, dans laquelle toute la deuxième face (57) de la deuxième couche de diélectrique (56), autour de la ligne de transmission à microbandes (80) et sa connexion à la ligne bifilaire équilibrée (70), est couverte par une couche de matériel absorbant de la radiofréquence (59).

7. Structure d'antenne selon l'une des revendications 1 à 6, dans laquelle l'épaisseur de la première couche est égale à au moins 1/8 de la longueur d'onde opérationnelle maximale.

8. Structure d'antenne selon l'une des revendications 1 à 7, dans laquelle l'épaisseur de la première couche est inférieure ou égale à la moitié de la longueur d'onde opérationnelle maximale.

9. Structure d'antenne selon l'une des revendications 1 à 8, dans laquelle un diamètre maximal ($D_o$) de l'élément rayonnant à spirale est compris entre 0,75 fois et 1.5 fois la longueur d'onde opérationnelle maximale ($\lambda_{max}$) :

$$0.75\ \lambda_{max} \leq D_o \leq 1.5\ \lambda_{max}$$

où : $D_o$ représente le diamètre extérieur maximal de l'élément rayonnant (60) et
$\lambda_{max}$ représente la longueur d'onde opérationnelle maximale.

10. Circuit imprimé (10) comprenant :

une structure d'antenne selon l'une des revendications 1 à 9 et
un composant hyperfréquence (20), connecté directement aux lignes de transmission à microbande (80).

11. Circuit imprimé (10) selon la revendication 10, ledit circuit imprimé (10) étant dépourvu de composant d'adaptation entre les lignes de transmission à microbande (80) et le composant hyperfréquence (20).

12. Circuit imprimé (10) selon l'une des revendications 10 ou 11, dans lequel :

le composant hyperfréquence (20) dont des entrées et des sorties balancées présentent une impédance prédéterminée,
l'élément rayonnant à spirale (60) et la ligne bifilaire équilibrée (70) présentent une impédance ($Z_{ant}$) environ égale à l'impédance des entrées et des sorties balancées du composant hyperfréquence (20), et
chacune des lignes de transmission à microbandes (80) présente une impédance sensiblement égale à une moitié de l'impédance prédéterminée.

13. Circuit imprimé (10) selon la revendication 12, dans lequel l'impédance prédéterminée est sensiblement égale à 100 $\Omega$.

14. Système d'imagerie à microondes comprenant au moins un circuit imprimé selon l'une des revendications 1 à 13.


**Patentansprüche**

1. Antennenstruktur, die in einer Leiterplatte (10) integriert ist, umfassend:

eine erste und eine zweite Dielektrizitätsschicht (52, 56), die eine selbige Dielektrizitätskonstante aber unterschiedliche Dicken haben, wobei die erste und die zweite Dielektrizitätsschicht (52, 56) jeweils eine erste Seite (51, 55) und eine zweite Seite (53, 57) aufweisen,
ein spiralförmiges symmetrisches Strahlerelement (60) auf einer ersten Seite (51) der ersten Dielektrizitätsschicht (52), und
eine symmetrische Versorgung der Antenne durch eine symmetrische Zweidrahtleitung (70), die eine selbige Impedanz wie das spiralförmige Strahlerelement (60) hat,
wobei die Antennenstruktur (50) **dadurch gekennzeichnet ist, dass**:

die symmetrische Zweidrahtleitung (70) die symmetrische Spiralantenne (60) mit einem Paar symmetrischer Mikrostreifen-Übertragungsleitungen (80) verbindet, die auf einer zweiten Seite (57) der zweiten Schicht (56) angeordnet sind, wobei jede Mikrostreifen-Übertragungsleitung (80) ausgelegt ist, um eine Impedanz aufzuweisen, die gleich der Hälfte der Impedanz der Zweidraht-Übertragungsleitung (70) ist, und
dadurch, dass sie ferner eine Massenebene (85) umfasst, die auf der ersten Seite (55) der zweiten Schicht (56) und auf der zweiten Seite (53) der ersten Schicht (52) in Übereinstimmung mit den Mikrostreifenleitungen (80) angeordnet ist, wobei die Massenebene (85) so konfiguriert ist, um, in Abhängigkeit von der Dicke der zweiten Dielektrizitätsschicht (56) und dem Abstand zwischen den Drähten der symmetrischen Zweidrahtleitung (70), die Impedanz der Übertragung der Mikrostreifen-Übertragungsleitungen (80) zu bestimmen.

2. Antennenstruktur nach Anspruch 1, wobei die Dielektrizitätskonstante der ersten Schicht (52) und der zweiten Schicht (56) größer oder gleich 2 und kleiner oder gleich 4 ist.

3. Antennenstruktur nach einem der Ansprüche 1 oder 2, wobei das spiralförmige Strahlerelement (60) von einer Wand (90) umgeben ist, die aus vertikalen Metallverbindungen (92) besteht.

4. Antennenstruktur nach Anspruch 3, wobei ein Schritt zwischen den Anschlüssen (92) kleiner als ¼ einer minimalen Arbeitswellenlänge des spiralförmigen Strahlerelements (60) ist.

5. Antennenstruktur nach einem der Ansprüche 3 oder 4, wobei ein mittlerer Innendurchmesser ($D_{ov}$) der Wand (90) in Abhängigkeit von einem maximalen Durchmesser ($D_o$) des spiralförmigen Strahlerelements (60) gemäß der folgenden Gleichung definiert ist:

$$(D_o + 0,005\ \lambda_{max}) \leqslant D_{ov} \leqslant (D_o + 0,25\ \lambda_{max})$$

wobei $D_{ov}$ den mittleren Innendurchmesser der Wand (90) repräsentiert, und
$D_o$ den maximalen Außendurchmesser des spiralförmigen Strahlerelements (60) repräsentiert.

6. Antennenstruktur nach einem der Ansprüche 1 bis 5, wobei die gesamte zweite Seite (57) der zweiten Dielektrizitätsschicht (56) um die Mikrostreifen-Übertragungsleitung (80) herum und ihre Verbindung mit der symmetrischen Zweidrahtleitung (70) von einer Schicht aus einem Material (59) bedeckt ist, das die Funkfrequenzen absorbiert.

7. Antennenstruktur nach einem der Ansprüche 1 bis 6, wobei die Dicke der ersten Schicht mindestens gleich 1/8 der maximalen Betriebswellenlänge ist.

8. Antennenstruktur nach einem der Ansprüche 1 bis 7, wobei die Dicke der ersten Schicht kleiner oder gleich der Hälfte der maximalen Betriebswellenlänge ist.

9. Antennenstruktur nach einem der Ansprüche 1 bis 8, wobei ein maximaler Durchmesser ($D_o$) des spiralförmigen Strahlerelements zwischen dem 0,75-fachen und dem 1,5-fachen der maximalen Betriebswellenlänge ($\lambda_{max}$) ist:

$$0,75\ \lambda_{max} \leqslant D_o \leqslant 1,5\ \lambda_{max}$$

wobei: $D_o$ den maximalen Außendurchmesser des Strahlerelements (60) repräsentiert, und
$\lambda_{max}$ die maximale Betriebswellenlänge repräsentiert.

10. Leiterplatte (10), umfassend:

   eine Antennenstruktur nach einem der Ansprüche 1 bis 9, und
   eine Höchstfrequenzkomponente (20), die direkt mit den Mikrostreifen-Übertragungsleitungen (80) verbunden ist.

11. Leiterplatte (10) nach Anspruch 10, wobei die Leiterplatte (10) keine Anpassungskomponente zwischen den Mikrostreifen-Übertragungsleitungen (80) und der Höchstfrequenzkomponente (20) aufweist.

12. Leiterplatte (10) nach einem der Ansprüche 10 oder 11, wobei:

   die Höchstfrequenzkomponente (20), deren Eingänge und Ausgänge balanciert sind, eine vorbestimmte Impedanz aufweist,
   das spiralförmige Strahlerelement (60) und die symmetrische Zweidrahtleitung (70) eine Impedanz ($Z_{ant}$) aufweisen, die ungefähr gleich der Impedanz der balancierten Eingänge und Ausgänge der Höchstfrequenzkomponente (20) ist, und
   jede der Mikrostreifen-Übertragungsleitungen (80) eine Impedanz aufweist, die im Wesentlichen gleich einer Hälfte der vorbestimmten Impedanz ist.

**13.** Leiterplatte (10) nach Anspruch 12, wobei die vorbestimmte Impedanz im Wesentlichen gleich 100 Ω ist.

**14.** Mikrowellen-Bildgebungssystem, mindestens eine Leiterplatte nach einem der Ansprüche 1 bis 13 umfassend.

**Claims**

**1.** An antenna structure integrated in a printed circuit board (10) comprising :

first and second dielectric layers (52, 56) having the same dielectric constant but different thicknesses, the first and second dielectric layers (52, 56) each having a first face (51, 55) and a second face (53, 57),
a balanced spiral radiating element (60) on a first face (51) of the first dielectric layer (52) and
a balanced antenna feed through a balanced twin-wire line (70) having the same impedance as the spiral radiating element (60),
the antenna structure (50) being **characterised in that**
the balanced twin-wire line (70) interconnects the balanced spiral antenna (60) to a pair of balanced microstrip transmission lines (80) positioned on a second face (57) of the second layer (56), where each microstrip transmission line (80) is adapted to have an impedance equal to half the impedance of the twin-wire transmission line (70) and
it further comprises a ground plane (85) positioned on the first face (55) of the second layer (56) and on the second face (53) of the first layer (52), in correspondence with the microstrip lines (80), the ground plane (85) being configured to determine, as a function of the thickness of the second dielectric layer (56) and of the distance between the wires of the balanced twin-wire line (70), the transmission impedance of the microstrip transmission lines (80).

**2.** The antenna structure of claim 1, wherein the dielectric constant of the first layer (52) and the second layer (56) is greater than or equal to 2 and less than or equal to 4.

**3.** Antenna structure according to one of claims 1 or 2, wherein the spiral radiating element (60) is surrounded by a wall (90) composed of vertical metal connections (92).

**4.** The antenna structure of claim 3, wherein a pitch between the connections (92) is less than ¼ of a minimum working wavelength of the spiral radiating element (60).

**5.** Antenna structure according to one of claims 3 or 4, wherein an average internal diameter ($D_{ov}$) of the wall (90) is defined as a function of a maximum diameter ($D_o$) of the spiral radiating element (60) according to the following equation:

$$(D_o + 0{,}005\lambda_{max}) \leq D_{ov} \leq (D_o + 0{,}25\lambda_{max})$$

where: $D_{ov}$ is the average internal diameter of the wall (90)
$D_o$ represents the maximum external diameter of the spiral radiating element (60).

**6.** Antenna structure according to one of claims 1 to 5, wherein the entire second face (57) of the second dielectric layer (56), around the microstrip transmission line (80) and its connection to the balanced twin-wire line (70), is covered by a layer of radio-frequency absorbing material (59).

**7.** Antenna structure according to one of claims 1 to 6, wherein the thickness of the first layer is equal to at least 1/8 of the maximum operational wavelength.

**8.** The antenna structure of any of claims 1 to 7, wherein the thickness of the first layer is less than or equal to half the maximum operating wavelength.

**9.** The antenna structure of any of claims 1 to 8, wherein a maximum diameter ($D_o$) of the spiral radiating element is between 0.75 times and 1.5 times the maximum operating wavelength ($\lambda_{max}$) :

$$0.75\ \lambda_{max} \leq D_o \leq 1.5\ \lambda_{max}$$

where: $D_o$ represents the maximum external diameter of the radiating element (60) and $\lambda_{max}$ represents the maximum operational wavelength.

10. Printed circuit board (10) comprising :

an antenna structure according to one of claims 1 to 9 and
a microwave component (20) connected directly to the microstrip transmission lines (80).

11. Printed circuit (10) according to claim 10, said printed circuit (10) being devoid of a matching component between the microstrip transmission lines (80) and the microwave component (20).

12. A printed circuit board (10) according to one of claims 10 or 11, wherein :

the microwave component (20) whose balanced inputs and outputs have a predetermined impedance,
the spiral radiating element (60) and the balanced twin-wire line (70) have an impedance ($Z_{ant}$) approximately equal to the impedance of the balanced inputs and outputs of the microwave component (20), and
each of the microstrip transmission lines (80) has an impedance substantially equal to half the predetermined impedance.

13. A printed circuit board (10) as claimed in claim 12, wherein the predetermined impedance is substantially equal to $100\Omega$ .

14. A microwave imaging system comprising at least one printed circuit according to one of claims 1 to 13.

**Fig. 1**

EP 3 928 378 B1

**Fig. 2**

EP 3 928 378 B1

**Fig. 3**

Fig. 4

EP 3 928 378 B1

**Fig. 5**

**Fig. 6**

**Fig. 7**

**Fig. 8**

**Fig. 9**

**Fig. 10**

**Fig. 11**

**Fig. 12**

**Fig. 13**

**Fig. 14**

**Fig. 15**

**Fig. 16**

**Fig. 17**

**EP 3 928 378 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5313216 A
- US 6137453 A
- US 8390529 B
- US 6335710 B
- US 2005243013 A